(19) Europäisches Patentamt

European Patent Office

Office européen des brevets

(11) **EP 4 671 790 A1**

(12) **EUROPEAN PATENT APPLICATION**

published in accordance with Art. 153(4) EPC

(43) Date of publication:
**31.12.2025 Bulletin 2026/01**

(21) Application number: **24781070.8**

(22) Date of filing: **12.03.2024**

(51) International Patent Classification (IPC):
*G01R 31/392* (2019.01)        *G01R 31/396* (2019.01)
*G01R 31/385* (2019.01)        *G01R 19/165* (2006.01)
*B60L 58/16* (2019.01)

(52) Cooperative Patent Classification (CPC):
**B60L 58/16; G01R 19/165; G01R 31/385;**
**G01R 31/392; G01R 31/396;** Y02E 60/10

(86) International application number:
**PCT/KR2024/003171**

(87) International publication number:
**WO 2024/205079 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 KR 20230042995**

(71) Applicant: **LG Energy Solution, Ltd.**
**Seoul 07335 (KR)**

(72) Inventors:
• **KIM, Ki Hoon**
  **Daejeon 34122 (KR)**
• **JUNG, Jin Won**
  **Daejeon 34122 (KR)**
• **JANG, Jin Woo**
  **Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND OPERATION METHOD THEREFOR**

(57)     A battery management apparatus according to an embodiment disclosed herein includes a data management unit configured to calculate a degradation degree (a state of health (SOH)) of each of a plurality of batteries and a controller configured to identify a plurality of target batteries based on a first value that is a deviation of the SOH of each of the plurality of batteries relative to an average of the SOHs of the plurality of batteries, divide the plurality of target batteries into a plurality of groups based on SOHs thereof, and diagnose at least one target battery based on deviations of open circuit voltages (OCVs) between a plurality of target batteries included in each of the plurality of groups.

200

```
┌─────────────────────┐        ┌─────────────────────┐
│ DATA MANAGEMENT     │        │                     │
│        UNIT         │────────│     CONTROLLER      │
│        210          │        │        220          │
└─────────────────────┘        └─────────────────────┘
```

FIG.2

**Description**

**[Technical Field]**

CROSS-REFERENCE TO RELATED APPLICATION

This application claims priority to and the benefit of Korean Patent Application No. 10-2023-0042995 filed in the Korean Intellectual Property Office on March 31, 2023, the entire content of which is incorporated herein by reference.

TECHNICAL FIELD

Embodiments disclosed herein relate to a battery management apparatus and an operating method thereof.

**[Background Art]**

An electric vehicle is supplied with electricity from outside to charge a battery cell, and then a motor is driven by a voltage charged in the battery cell to obtain power. A battery cell undergoes internal deformation and denaturation through various chares/discharges in production and use phases, such that physical and chemical characteristics thereof change, causing an inner short-circuit. When the inner short-circuit occurs in the battery cell, an under-voltage defect may occur in which a voltage of the battery cell decreases to a predetermined level or less and a possibility of ignition increases, resulting in a direct problem in the battery cell. Thus, a technique for determining whether the inner short-circuit occurs in the battery cell is required.

In a battery system in which a plurality of battery cells are coupled, a conventional battery management apparatus diagnoses an inner short-circuit by determining a relative voltage deviation according to a coupling order of the battery cells without considering a difference in degree of degradation (state of health (SOH)) of each battery cell. Such a method has a limitation of failing to detect a voltage fluctuation of a battery cell occurring due to an actual inner short-circuit because a capacity deviation corresponding to accumulation of use and natural degradation of a battery cell is not considered.

**[Disclosure]**

**[Technical Problem]**

Embodiments disclosed herein aim to provide a battery management apparatus and an operating method thereof in which an abnormal battery cell may be accurately diagnosed by reflecting a voltage deviation corresponding to a difference in degradation degree between battery cells.

Technical problems of the embodiments disclosed herein are not limited to the above-described technical problems, and other unmentioned technical problems would be clearly understood by one of ordinary skill in the art from the following description.

**[Technical Solution]**

A battery management apparatus according to an embodiment disclosed herein includes a data management unit configured to calculate a degradation degree (a state of health (SOH)) of each of a plurality of batteries and a controller configured to identify a plurality of target batteries based on a first value that is a deviation of the SOH of each of the plurality of batteries relative to an average of the SOHs of the plurality of batteries, divide the plurality of target batteries into a plurality of groups based on SOHs thereof, and diagnose at least one target battery based on deviations of open circuit voltages (OCVs) between a plurality of target batteries included in each of the plurality of groups.

According to an embodiment, the controller may be further configured to identify, as the plurality of target batteries, batteries having the first value being less than a threshold among the plurality of batteries.

According to an embodiment, the controller may be further configured to divide the plurality of target batteries into a plurality of groups in an order in which the plurality of target batteries are listed in a descending order of the SOHs thereof.

According to an embodiment, the controller may be further configured to calculate a deviation of an OCV of each of a plurality of target batteries included in each of the plurality of groups relative to an average of OCVs of the plurality of target batteries and calculate a variance of the deviation of the OCV of each of the plurality of target batteries included in each of the plurality of groups.

According to an embodiment, the controller may be further configured to calculate a pattern of the variance of the deviation of the OCV of each of the plurality of target batteries by calculating the variance of the deviation of the OCV of each of the plurality of target batteries every specific periods, and diagnose at least one target battery by comparing the pattern of the variance of the deviation of the OCV of each of the plurality of target batteries with a plurality of diagnosis patterns.

According to an embodiment, the controller may be further configured to diagnose at least one target battery among the plurality of target batteries when a pattern of a variance of a deviation of an OCV of the at least one target battery corresponds to any one of the plurality of diagnosis patterns.

An operating method of a battery management apparatus according to an embodiment disclosed herein includes calculating a degradation degree (a state of health (SOH)) of each of a plurality of batteries, calculating a first value that is a deviation of the SOH of each of the plurality of batteries relative to an average of the SOHs of the plurality of batteries, identifying a plurality of target batteries based on the first value of each of the plurality of batteries, dividing the plurality of target batteries into a plurality of groups based on SOHs thereof, and diagnosing at least one target battery based on deviations of open circuit voltages (OCVs) between a plurality of target batteries included in each of the plurality of groups.

According to an embodiment, the identifying of the plurality of target batteries based on the first value of each of the plurality of batteries may include identifying, as the plurality of target batteries, batteries having the first value being less than a threshold among the plurality of batteries.

According to an embodiment, the dividing of the plurality of target batteries into the plurality of groups based on the SOHs thereof may include dividing the plurality of target batteries into a plurality of groups in an order in which the plurality of target batteries are listed in a descending order of the SOHs thereof.

According to an embodiment, the diagnosing of the at least one target battery based on the deviations of the OCVs between the plurality of target batteries included in each of the plurality of groups may include calculating a deviation of an OCV of each of a plurality of target batteries included in each of the plurality of groups relative to an average of OCVs of the plurality of target batteries and calculating a variance of the deviation of the OCV of each of the plurality of target batteries included in each of the plurality of groups.

According to an embodiment, the diagnosing of the at least one target battery based on the deviations of the OCVs between the plurality of target batteries included in each of the plurality of groups may include calculating a pattern of the variance of the deviation of the OCV of each of the plurality of target batteries by calculating the variance of the deviation of the OCV of each of the plurality of target batteries every specific periods, and diagnosing at least one target battery by comparing the pattern of the variance of the deviation of the OCV of each of the plurality of target batteries with a plurality of diagnosis patterns.

According to an embodiment, the diagnosing of the at least one target battery based on the deviations of the OCVs between the plurality of target batteries included in each of the plurality of groups may include diagnosing at least one target battery among the plurality of target batteries when a pattern of a variance of a deviation of an OCV of the at least one target battery corresponds to any one of the plurality of diagnosis patterns.

**[Advantageous Effects]**

With the battery management apparatus and the operating method thereof according to an embodiment disclosed herein, an abnormal battery cell may be accurately diagnosed by reflecting a voltage deviation corresponding to a difference in degradation degree between battery cells.

**[Description of Drawings]**

FIG. 1 illustrates a battery pack according to an embodiment disclosed herein.

FIG. 2 is a block diagram illustrating a configuration of a battery management apparatus, according to an embodiment disclosed herein.

FIG. 3 is a table showing degradation degrees of battery cells according to an embodiment disclosed herein.

FIG. 4 is a table showing first values of battery cells according to an embodiment disclosed herein.

FIG. 5 is a table showing a table listing target battery cells in a descending order with respect to a degradation degree, according to an embodiment disclosed herein.

FIG. 6 is a flowchart of a diagnosis method of a target battery cell of a controller, according to an embodiment disclosed herein.

FIG. 7 is a flowchart showing an operating method of a battery management apparatus, according to an embodiment disclosed herein.

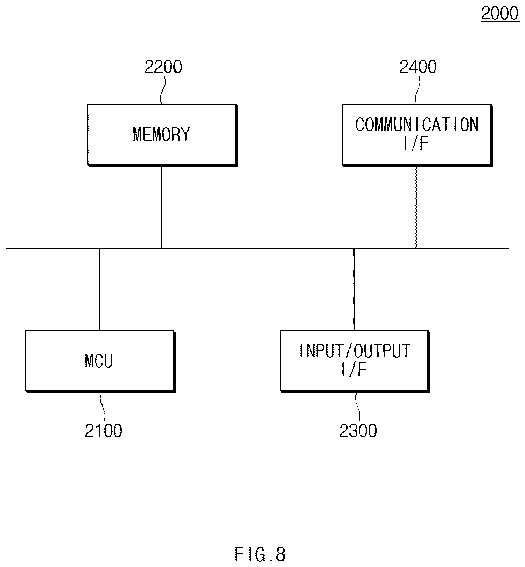

FIG. 8 is a block diagram showing a hardware configuration of a computing system for performing an operating method of a battery management apparatus, according to an embodiment disclosed herein.

**[Mode for Invention]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

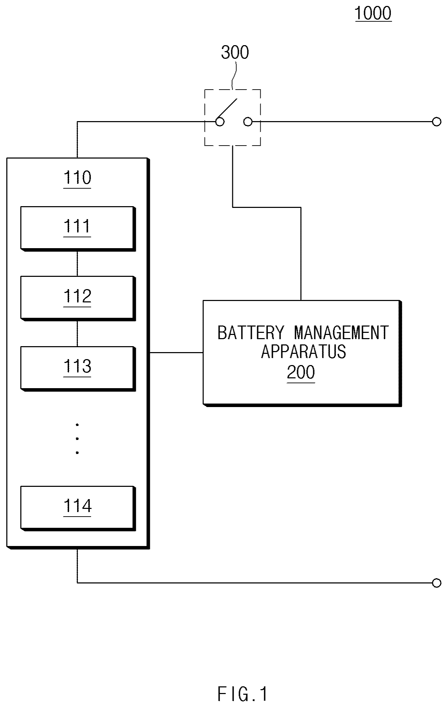

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

While it is shown in FIG. 1 that the battery module 100 is one, the battery pack 1000 may include a plurality of battery modules that form a stacked structure. The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus (a battery management system (BMS)) 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

For the plurality of battery cells 110, 120, 130, and 140, as a period of use or the number of times of use increases, a capacity may decrease, internal resistance may increase, and various factors of the battery may change. The battery management apparatus 200 may diagnose an abnormal phenomenon inside the plurality of battery cells 110, 120, 130, and 140 based on data of various factors changing with deterioration of the battery.

More specifically, the battery management apparatus 200 may determine internal abnormal voltages of the plurality of battery cells 110, 120, 130, and 140 based on data of various factors changing with deterioration of the plurality of battery cells 110, 120, 130, and 140 to determine whether an abnormal battery cell exists inside the plurality of battery banks 110, 120, 130, and 140.

For example, the battery management apparatus 200 may calculate deviations dV of open circuit voltages (OCVs) of the plurality of battery cells 110, 120, 130, and 140 through OCV data of the plurality of battery cells 110, 120, 130, and 140. The battery management apparatus 200 may diagnose whether an inner short-circuit of at least one battery cell among the plurality of battery cells 110, 120, 130, and 140 occurs by using an average of the deviations of the OCVs of the plurality of battery cells 110, 120, 130, and 140 and the deviation of the OCV of each of the plurality of battery cells 110, 120, 130, and 140. A battery cell in which an inner short-circuit occurs may have a voltage deviation with a normal battery cell due to self-discharge over time.

The battery management apparatus 200 may determine a plurality of target battery cells except for a battery cell with a suspected noise voltage by comparing an average of the SOHs of the plurality of battery cells 110, 120, 130, and 140 included in the battery pack 1000 with a degradation degree of each of the plurality of battery cells 110, 120, 130, and 140. After determining a plurality of target battery cells, the battery management apparatus 200 may diagnose a battery cell having an inner short-circuit occurring by using a variance of the deviations dV of the OCVs of the plurality of target battery cells included in the battery pack 1000.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

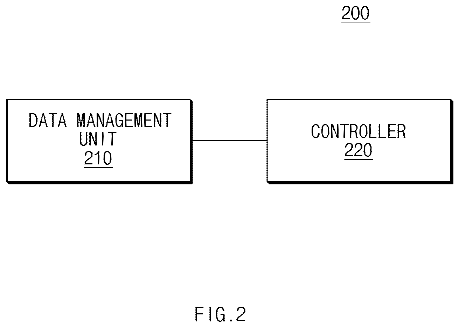

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a data management unit 210 and a controller 220.

The data management unit 210 may calculate a degradation degree (SOH) of each of the plurality of battery cells 110, 120, 130, and 140. The SOH is an index indicating a health state or life state of the battery in the current state with respect to an initial state of the battery. A moment at which the SOH reaches 0 % may be defined as an end of life (EOL). In addition, the end of life of the battery may be a moment at which the capacity of the battery reaches a guaranteed capacity or less. For example, the battery management apparatus 210 may calculate the SOH of the plurality of battery cells 110, 120, 130, and 140 based on at least any one factor of internal resistance, impedance, conductance, capacity, voltage, self-discharge current, charge performance, and the number of times of charge and discharge of the plurality of battery cells 110, 120, 130, and 140, which change with deterioration of the plurality of battery cells 110, 120, 130, and 140.

For example, the data management unit 210 may calculate an individual SOH, i.e., an SOHC of each battery cell by using the OCVs and current integrated value of the plurality of battery cells 110, 120, 130, and 140. Specifically, the battery management apparatus 200 may calculate before-charge OCV OCV_A and after-charge OCV OCV_B of the plurality of battery cells 110, 120, 130, and 140.

The data management unit 210 may calculate SOC_A and SOC_B by changing OCV_A and OCV_B into the amount of charge, i.e., SOCs, based on an OCV table. The battery management apparatus 200 may calculate individual SOHs of the plurality of battery cells 110, 120, 130, and 140, based on [Equation 1].

$$[\text{Equation 1}]$$

$$SOHC = I/((SOC\_B - SOC\_A)/100 * X) * 100$$

Herein, (SOC_B - SOC_A) may mean an SOC deviation, I may mean an accumulated charging current, and X may mean a capacity of an existing battery cell. The data management unit 210 may calculate an individual SOH, i.e., an SOHC, of each of the plurality of battery cells 110, 120, 130, and 140, based on [Equation 1].

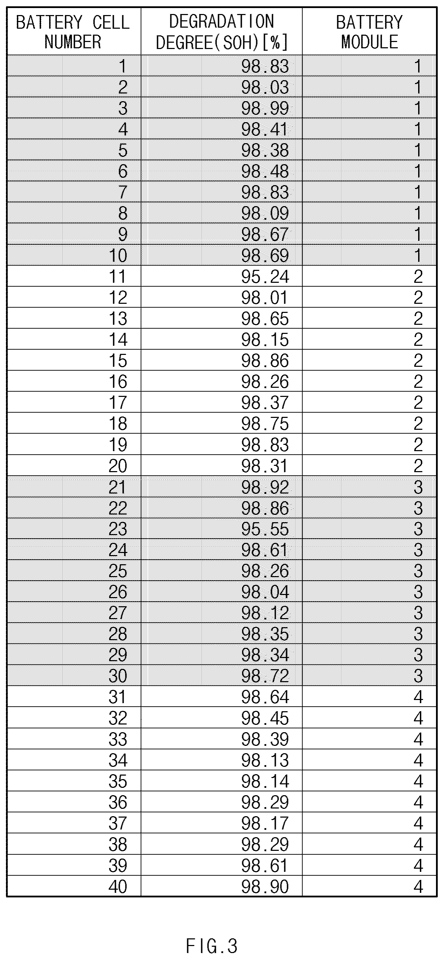

FIG. 3 is a table showing SOHs of battery cells according to an embodiment disclosed herein.

Referring to FIG. 3, the data management unit 210 may calculate individual SOHs of the plurality of battery cells, i.e., SOHCs.

According to an embodiment, the battery pack 1000 may include a stacked structure of 4 battery modules 100, and each of the plurality of battery modules 100 may include 10 battery cells connected in series or in parallel. That is, the battery pack 1000 may include, for example, 40 battery cells, in which each of 4 battery modules may be given a unique battery module number and each of the 40 battery cells included in the battery modules may be given a unique battery cell number. The data management unit 210 may calculate individual SOHs of the 40 battery cells included in the battery pack 1000, i.e., SOHCs.

The controller 220 may diagnose at least one battery cell among the plurality of battery cells 110, 120, 130, and 140, based on an SOHC of each of the plurality of battery cells 110, 120, 130, and 140.

First, the controller 220 may identify a plurality of target battery cells based on the SOHs of the plurality of battery cells 110, 120, 130, and 140.

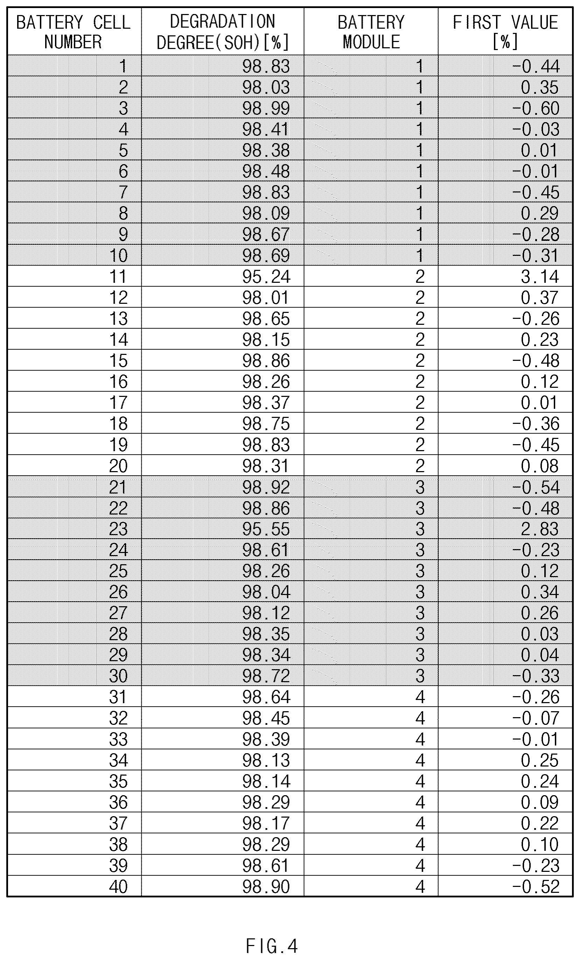

FIG. 4 is a table showing first values of battery cells according to an embodiment disclosed herein.

Referring to FIG. 4, for example, the controller 220 may calculate an average of the SOHs of the 40 battery cells included in the battery module 100. For example, the controller 220 may calculate, as '98.39 %', the average of the SOHs, i.e., SOHCs of the 40 battery cells included in the battery module 100.

The controller 220 may calculate a first value that is a deviation of the SOH of each of the plurality of battery cells relative to the average of the SOHs of the plurality of battery cells. For example, when an SOHC of a battery cell having a battery cell number of 1 is '98.83 %', the controller 220 may calculate the first value of the 1st battery cell as '-0.44 %'.

The controller 220 may identify, as a plurality of target battery cells, a battery having the first value less than a threshold, among the plurality of battery cells 110, 120, 130, and 140. Herein, the threshold value may be defined as a criterion for determining 'abnormality' because an extreme result is output. That is, the threshold value may be defined as a criterion indicating a degree to which data contradicts a particular statistical model. The controller 220 may determine, as a noise battery cell, a battery cell having the first value exceeding the threshold among the plurality of battery cells 110, 120, 130, and 140, remove data of the noise battery cell, and identify battery cells from which the noise battery cell is removed as target battery cells.

For example, the controller 220 may identify, as target battery cells, among the 40 battery cells, the other 37 battery cells than 3 noise battery cells having the first value, which is a deviation of an SOH of a battery cell, exceeding a threshold of '2 %' relative to the average of '98.39 %' of the SOHs of the battery cells.

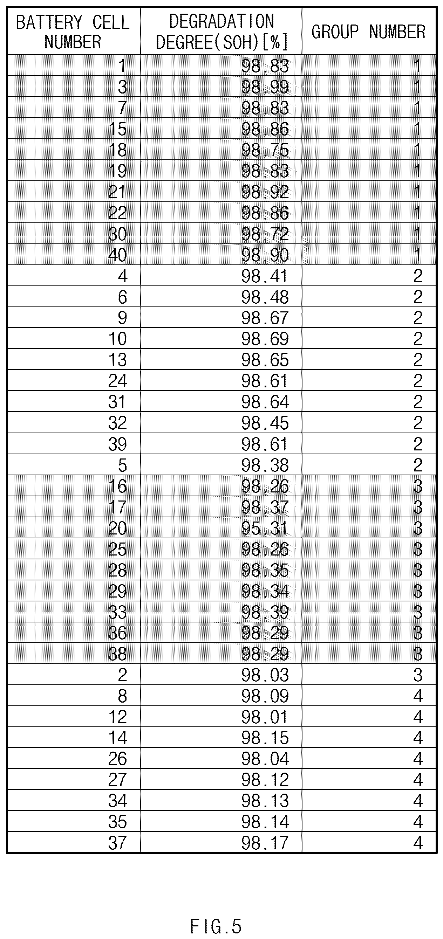

FIG. 5 is a table showing a table listing target battery cells in a descending order with respect to a degradation degree, according to an embodiment disclosed herein.

Referring to FIG. 5, the controller 220 may divide a plurality of target battery cells into a plurality of groups based on SOHs. Specifically, the controller 220 may list the plurality of target battery cells based on the SOHs thereof and divide the plurality of target battery cells into a plurality of groups according to a listing order.

The controller 220 may list the plurality of target battery cells in order of high SOHs. That is, the controller 220 may list the plurality of target battery cells in a descending order of SOHs. For example, the controller 220 may list 37 target battery cells other than noise battery cells among 100 battery cells included in the battery pack 1000 in a descending order of SOHs of the battery cells.

The controller 220 may list the plurality of target battery cells in order of high SOHs, divide battery cells having similar SOHs into a plurality of groups, and perform diagnosis. For example, the controller 220 may list 37 target battery cells based on SOHs thereof and divide them into 4 groups, each including 8 to 10 battery cells.

The controller 220 may diagnose at least one target battery cell based on deviations of OCVs between a plurality of target battery cells included in each of the plurality of groups.

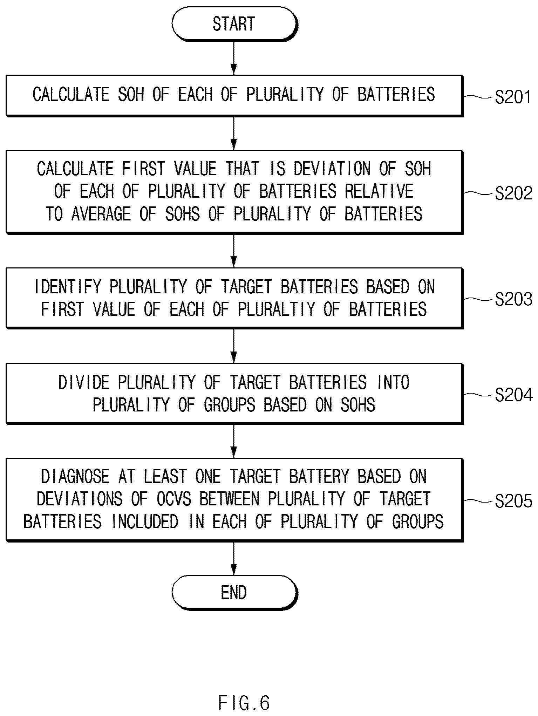

FIG. 6 is a flowchart of a diagnosis method of a target battery cell of a controller, according to an embodiment disclosed herein.

Referring to FIG. 6, a detailed description will be made of a method, performed by the controller 220, of diagnosing at least one target battery cell based on deviations of OCVs between target battery cells.

In operation S101, the controller 220 may determine whether OCVs of a plurality of target battery cells included in each of a plurality of groups are in a relaxation state. Herein, voltage relaxation may mean a phenomenon in which a potential difference occurs between a plurality of positive electrode materials when a battery enters an idle state or an unloaded state, and movement of operating ions between the positive electrode materials is caused due to the potential difference, such that the potential difference is resolved over time. In operation S101, for example, when a jitter of a voltage of a plurality of target battery cells included in each of the plurality of groups is 20 mV or less for 4 hours, the controller 220 may determine that the plurality of target battery cells are in a voltage relaxation state.

In operation S101, the controller 220 may determine whether a specific period has elapsed after the plurality of target battery cells included in each of the plurality of groups are in the voltage relaxation state. In operation S101, for example, the controller 220 may determine whether 10 days have elapsed after the plurality of target battery cells included in each of the plurality of groups are in the voltage relaxation state.

In operation S102, the controller 220 may measure an OCV of each of the plurality of target battery cells included in each of the plurality of groups after a preset period has elapsed.

In operation S102, the controller 220 may calculate an average of the OCVs of the plurality of target battery cells included in each of the plurality of groups. In operation S102, the controller 220 may calculate an average of OCVs of each of the plurality of groups into which the plurality of target battery cells having similar deterioration degrees are grouped. In operation S102, for example, the controller 220 may classify the 37 target battery cells into a first group G1, a second group G2, a third group G3, and a fourth group G4, and calculate an average Vavg_1 of OCVs of the first group G1, an average Vavg_2 of OCVs of the second group G2, an average Vavg_3 of OCVs of the third group G3, and an average Vavg_4 of OCVs of the fourth group G4.

In operation S103, the controller 220 may calculate the deviation dV of the OCV of each of the plurality of target battery cells relative to the average of the OCVs of each of the plurality of groups. In operation S103 for example, the controller 220 may calculate the deviation of the OCV of each of the plurality of target battery cells relative to the average Vavg_1 of the OCVs of the first group G1.

In operation S103, for example, when the current time is set to 'T', the controller 220 may calculate the deviation dV of the OCV of each of the plurality of battery cells at the past times 'T-4', 'T-3', 'T-2', and 'T-1', and the current time 'T'. In operation S103, the controller 220 may calculate a first OCV deviation dv_"T-4", which is the deviation of the OCV of each target battery cell, calculated at the time 'T-4', a second OCV deviation dv_"T-3", which is the deviation of the OCV of each target battery cell, calculated at the time 'T-3', a third OCV deviation dv_"T-2", which is the deviation of the OCV of each target battery cell, calculated at the time 'T-2', a fourth OCV deviation dv_"T-1", which is the deviation of the OCV of each target battery cell, calculated at the time 'T-1', and a fifth OCV deviation dv_"T", which is the deviation of the OCV of each target battery cell, calculated at the time 'T'.

In operation S104, the controller 220 may calculate a variance $\triangle$dV of the deviation of the OCV of each of the plurality of target battery cells included in each of the plurality of groups. In operation S104, specifically, the controller 220 may continuously calculate an OCV of each of the plurality of target battery cells every specific periods to calculate the variance $\triangle$dV of the deviation of the OCV of each of the plurality of target battery cells, calculated in the current period, relative to the deviation of the OCV of each of the plurality of target battery cells, calculated in a previous period.

In operation S104, the controller 220 may continuously calculate the variance $\triangle$dV of the deviation of the OCV of each of the plurality of target battery cells every specific periods.

In operation S104, for example, the controller 220 may calculate a first voltage deviation variance $\Delta$dV_"T-3", which is a variance of the second OCV voltage deviation dV_"T-3" that is the deviation of the OCV of each of the plurality of target cells, calculated at the time 'T-3' relative to the first OCV deviation dV_"T-4" that is the deviation of the OCV of each of the plurality of target cells, calculated at the time 'T-4'.

In operation S104, for example, the controller 220 may calculate a second voltage deviation variance $\Delta$dV_"T-2", which is a variance of the third OCV voltage deviation dV_"T-2" that is the deviation of the OCV of each of the plurality of target cells, calculated at the time 'T-2' relative to the second OCV deviation dV_"T-3" that is the deviation of the OCV of each of the plurality of target cells, calculated at the time 'T-3'.

In operation S104, for example, the controller 220 may calculate a third voltage deviation variance $\Delta$dV_"T-1", which is a variance of the fourth OCV voltage deviation dV_"T-1" that is the deviation of the OCV of each of the plurality of target cells, calculated at the time 'T-1' relative to the third OCV deviation dV_"T-2" that is the deviation of the OCV of each of the plurality of target cells, calculated at the time 'T-2'.

In operation S104, for example, the controller 220 may calculate a fourth voltage deviation variance $\Delta$dV_"T", which is a variance of the fifth OCV voltage deviation dV_"T" that is the deviation of the OCV of each of the plurality of target cells, calculated at the time 'T' relative to the fourth OCV deviation dV_"T-1" that is the deviation of the OCV of each of the plurality of target cells, calculated at the time 'T- 1'.

In operation S105, the controller 220 may calculate a pattern of the variance of the deviation of the OCV of each of the plurality of target battery cells. In operation S105, for example, the controller 220 may calculate the pattern of the variance of the deviation of the OCV of each of the plurality of target battery cells, by using the first voltage deviation variance $\Delta$dV_"T-3", which is the variance of the deviation of the OCV of each of the plurality of target battery cells, calculated at the time 'T-3', the second voltage deviation variance $\Delta$dV_"T-2", which is the variance of the deviation of the OCV of each of the plurality of target battery cells, calculated at the time 'T-2', the third voltage deviation variance $\Delta$dV_"T-1", which is the deviation of the OCV of each of the plurality of target cells, calculated at the time 'T-1', and the fourth voltage deviation variance $\Delta$ dV_"T", which is the deviation of the OCV of each of the plurality of target cells, calculated at the time 'T'.

In operation S106, the controller 220 may diagnose at least one target battery cell by using the pattern of the variance of the deviation of the OCV of each of the plurality of target battery cells. In operation S106, specifically, the controller 220 may diagnose at least one target battery cell based on at least any one of the pattern of the variance of the deviation of the OCV of each of the plurality of target battery cells, and a sum and a magnitude of variances of deviations of the OCVs.

In operation S106, according to an embodiment, the controller 220 may diagnose at least one target battery cell by comparing the pattern of the variance of the deviation of the OCV of each of the plurality of target battery cells with a plurality of pre-stored diagnosis patterns. Herein, the plurality of pre-stored diagnosis patterns may include a pattern of diagnosing a state of a battery cell with respect to a sum of variances $\Delta$dV of a deviation of an OCV of a target battery cell, a pattern of diagnosing the state of the battery cell with respect to a magnitude of each variance of the deviation of the OCV of the target battery cell, a pattern of diagnosing the state of the battery cell with respect to a maximum magnitude or a minimum magnitude of the variance $\Delta$dV of the deviation of the OCV of the target battery cell, and a pattern of diagnosing the state of the battery cell with respect to an increase or decrease trend of the variance $\Delta$dV of the deviation of the OCV of the target battery cell.

When a pattern of a variance of a deviation of an OCV of at least one target battery cell among the plurality of target battery cells corresponds to any one of a plurality of diagnosis patterns, the controller 220 may diagnose that an inner short-circuit occurs in the corresponding target battery cell.

When the controller 220 determines that the inner short-circuit occurs in a battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

As described above, the battery management apparatus 200 according to an embodiment disclosed herein may accurately diagnose a battery cell having an inner short-circuit occurring, by reflecting a voltage deviation with respect to a difference between SOHs of battery cells.

A conventional battery management apparatus may misdiagnose a battery cell having a voltage deviation with respect to an SOH difference because of ignoring an SOH difference between battery cells, but the battery management apparatus 200 according to an embodiment disclosed herein may improve the accuracy of diagnosis of an inner short-circuit due to comparison between battery cells having similar degradation degrees.

Moreover, the battery management apparatus 200 may compare variances of deviations of a plurality of OCVs of each of a plurality of battery cells to analyze features of short-term voltage behavior and long-term voltage behavior of the battery cells.

The battery management apparatus 200 may secure safety and reliability of battery energy by early diagnosing a battery cell having an inner short-circuit occurring using variances of deviations of OCVs of the battery cells. In addition, the battery management apparatus 200 may diagnose quickly and conveniently the battery cell because of no need to remove the battery cell having the inner short-circuit occurring in the state of the battery being mounted on a vehicle.

FIG. 6 is a flowchart showing an operating method of a battery management apparatus, according to an embodiment disclosed herein.

Hereinbelow, an operating method of the battery management apparatus 200 will be described with reference to FIGS. 1 to 5.

The battery management apparatus 200 may be substantially the same as the battery management apparatus 200 described with reference to FIGS. 1 to 5, and thus will be briefly described to avoid redundant description.

Referring to FIG. 6, an operating method of the battery management apparatus may include operation S201 of calculating an SOH of each of a plurality of batteries, operation S202 of calculating a first value, which is a deviation of the SOH of each of the plurality of batteries relative to an average of the SOHs of the plurality of batteries, operation S203 of identifying a plurality of target battery cells based on the first value of each of the plurality of batteries, operation S204 of dividing the plurality of target battery cells into a plurality of groups based on the SOHs, and operation S205 of diagnosing at least one target battery cell based on deviations of OCVs between a plurality of target batteries included in each of the plurality of groups.

Hereinbelow, operations S201 through S205 will be described in detail.

In operation S201, the data management unit 210 may calculate an SOH of each of the plurality of battery cells 110, 120, 130, and 140. The SOH is an index indicating a health state or life state of the battery in the current state with respect to an initial state of the battery. In operation S201, for example, the battery management apparatus 210 may calculate the SOH of the plurality of battery cells 110, 120, 130, and 140 based on at least any one factor of internal resistance, impedance, conductance, capacity, voltage, self-discharge current, charge performance, and the number of times of charge and discharge of the plurality of battery cells 110, 120, 130, and 140, which change with deterioration of the plurality of battery cells 110, 120, 130, and 140.

In operation S201, for example, the data management unit 210 may calculate an individual SOH, i.e., an SOHC of each battery cell by using the OCVs and current integrated value of the plurality of battery cells 110, 120, 130, and 140.

In operation S201, specifically, the battery management apparatus 200 may calculate before-charge OCV OCV_A and after-charge OCV OCV_B of the plurality of battery cells 110, 120, 130, and 140. In operation S201, the data management unit 210 may calculate SOC_A and SOC_B by changing OCV_A and OCV_B into the amount of charge, i.e., SOCs, based on an OCV table. The battery management apparatus 200 may calculate individual SOHs of the plurality of battery cells 110, 120, 130, and 140, based on [Equation 1].

$$[\text{Equation 1}]$$

$$SOHC = I/((SOC\_B - SOC\_A)/100 * X) * 100$$

Herein, (SOC_B - SOC_A) may mean an SOC deviation, I may mean an accumulated charging current, and X may mean a capacity of an existing battery cell. In operation S201, the data management unit 210 may calculate an individual SOH, i.e., an SOHC, of each of the plurality of battery cells 110, 120, 130, and 140, based on [Equation 1].

In operation S201, the data management unit 210 may calculate individual SOHs of the plurality of battery cells, i.e., SOHCs.

In operation S201, according to an embodiment, the battery pack 1000 may include a stacked structure of 4 battery modules 100, and each of the plurality of battery modules 100 may include 10 battery cells connected in series or in parallel. That is, the battery pack 1000 may include, for example, 40 battery cells, in which each of 4 battery modules may be given a unique battery module number and each of the 40 battery cells included in the battery modules may be given a unique battery cell number. In operation S201, the data management unit 210 may calculate individual SOHs of the 40 battery cells included in the battery pack 1000, i.e., SOHCs.

In operation S202, the controller 220 may calculate an average of the SOHs of the 40 battery cells included in the battery module 100.

In operation S202, the controller 220 may calculate a first value that is a deviation of the SOH of each of the plurality of battery cells relative to the average of the SOHs of the plurality of battery cells.

In operation S203, the controller 220 may identify, as a plurality of target battery cells, a battery having the first value less than a threshold, among the plurality of battery cells 110, 120, 130, and 140.

In operation S203, the controller 220 may determine, as a noise battery cell, a battery cell having the first value exceeding the threshold among the plurality of battery cells 110, 120, 130, and 140, remove data of the noise battery cell, and identify battery cells from which the noise battery cell is removed as target battery cells.

In operation S203, for example, the controller 220 may identify, as target battery cells, among the 40 battery cells, the other 37 battery cells than 3 noise battery cells having the first value, which is a deviation of an SOH of a battery cell, exceeding a threshold of '2 %' relative to the average of '98.39 %' of the SOHs of the battery cells.

In operation S204, the controller 220 may divide a plurality of target battery cells into a plurality of groups based on SOHs. In operation S204, specifically, the controller 220 may list the plurality of target battery cells based on the SOHs thereof and divide the plurality of target battery cells into a plurality of groups according to a listing order. In operation S204, according to an embodiment, the controller 220 may list the plurality of target battery cells in order of high SOHs. That is, the controller 220 may list the plurality of target battery cells in a descending order of SOHs.

In operation S204, the controller 220 may list the plurality of target battery cells based on SOHs, divide battery cells having similar SOHs into a plurality of groups, and perform diagnosis. In operation S204, for example, the controller 220 may list 37 target battery cells based on SOHs thereof and divide them into 4 groups, each including 8 to 10 battery cells.

In operation S205, the controller 220 may diagnose at least one target battery cell based on deviations of OCVs between a plurality of target battery cells included in each of the plurality of groups.

In operation S205, the controller 220 may determine whether OCVs of a plurality of target battery cells included in each of a plurality of groups are in a relaxation state. Herein, voltage relaxation may mean a phenomenon in which a potential difference occurs between a plurality of positive electrode materials when a battery enters an idle state or an unloaded state, and movement of operating ions between the positive electrode materials is caused due to the potential difference, such that the potential difference is resolved over time.

In operation S205, the controller 220 may determine whether a specific period has elapsed after the plurality of target battery cells included in each of the plurality of groups are in the voltage relaxation state. In operation S205, for example, the controller 220 may determine whether 10 days have elapsed after the plurality of target battery cells included in each of the plurality of groups are in the voltage relaxation state.

In operation S205, the controller 220 may measure an OCV of each of the plurality of target battery cells included in each of the plurality of groups after a preset period has elapsed.

In operation S205, the controller 220 may calculate an average of the OCVs of the plurality of target battery cells included in each of the plurality of groups. That is, the controller 220 may calculate an average of OCVs of each of the plurality of groups into which the plurality of target battery cells having similar deterioration degrees are grouped. In operation S205, for example, the controller 220 may classify the 37 target battery cells into a first group G1, a second group G2, a third group G3, and a fourth group G4, and calculate an average Vavg_1 of OCVs of the first group G1, an average Vavg_2 of OCVs of the second group G2, an average Vavg_3 of OCVs of the third group G3, and an average Vavg_4 of OCVs of the fourth group G4.

In operation S205, the controller 220 may calculate the deviation dV of the OCV of each of the plurality of target battery cells relative to the average of the OCVs of each of the plurality of groups. In operation S205 for example, the controller 220 may calculate the deviation of the OCV of each of the plurality of target battery cells relative to the average Vavg_1 of the OCVs of the first group G1.

In operation S205, the controller 220 may calculate a variance $\triangle dV$ of the deviation of the OCV of each of the plurality of target battery cells included in each of the plurality of groups. In operation S205, the controller 220 may continuously calculate an OCV of each of the plurality of target battery cells every specific periods to calculate the variance $\triangle dV$ of the deviation of the OCV of each of the plurality of target battery cells, calculated in the current period, relative to the deviation of the OCV of each of the plurality of target battery cells, calculated in a previous period. In operation S205, the controller 220 may continuously calculate the variance $\triangle dV$ of the deviation of the OCV of each of the plurality of target battery cells every specific periods.

In operation S205, for example, when the current time is set to 'T', the controller 220 may calculate the deviation dV of the OCV of each of the plurality of battery cells at the past times 'T-4', 'T-3', 'T-2', and 'T1', and the current time 'T'.

In operation S205, the controller 220 may calculate a first OCV deviation dv_"T-4", which is the deviation of the OCV of each target battery cell, calculated at the time 'T-4', a second OCV deviation dv_"T-3", which is the deviation of the OCV of each target battery cell, calculated at the time 'T-3', a third OCV deviation dv_"T-2", which is the deviation of the OCV of each target battery cell, calculated at the time 'T-2', a fourth OCV deviation dv_"T-1", which is the deviation of the OCV of each target battery cell, calculated at the time 'T-1', and a fifth OCV deviation dv_"T", which is the deviation of the OCV of each target battery cell, calculated at the time 'T'.

In operation S205, the controller 220 may calculate a first voltage deviation variance ΔdV_"T-3", which is a variance of the second OCV voltage deviation dV_"T-3" that is the deviation of the OCV of each of the plurality of target cells, calculated at the time 'T-3' relative to the first OCV deviation dV_"T-4" that is the deviation of the OCV of each of the plurality of target cells, calculated at the time 'T-4'.

In operation S205, the controller 220 may calculate a second voltage deviation variance ΔdV_"T-2", which is a variance of the third OCV voltage deviation dV_"T-2" that is the deviation of the OCV of each of the plurality of target cells, calculated at the time 'T-2' relative to the second OCV deviation dV_"T-3" that is the deviation of the OCV of each of the plurality of target cells, calculated at the time 'T-3'.

In operation S205, the controller 220 may calculate a third voltage deviation variance ΔdV_"T-1", which is a variance of the fourth OCV voltage deviation dV_"T-1" that is the deviation of the OCV of each of the plurality of target cells, calculated at the time 'T-1' relative to the third OCV deviation dV_"T-2" that is the deviation of the OCV of each of the plurality of target cells, calculated at the time 'T-2'.

In operation S205, the controller 220 may calculate a fourth voltage deviation variance ΔdV_"T", which is a variance of the fifth OCV voltage deviation dV_"T" that is the deviation of the OCV of each of the plurality of target cells, calculated at the time 'T' relative to the fourth OCV deviation dV_"T-1" that is the deviation of the OCV of each of the plurality of target cells, calculated at the time 'T-1'.

In operation S205, the controller 220 may calculate a pattern of the variance of the deviation of the OCV of each of the plurality of target battery cells. For example, the controller 220 may calculate the pattern of the variance of the deviation of the OCV of each of the plurality of target battery cells, by using the first voltage deviation variance ΔdV_"T-3", which is the variance of the deviation of the OCV of each of the plurality of target battery cells, calculated at the time 'T-3', the second voltage deviation variance Δ dV_"T-2", which is the variance of the deviation of the OCV of each of the plurality of target battery cells, calculated at the time 'T-2', the third voltage deviation variance Δ dV_"T-1", which is the deviation of the OCV of each of the plurality of target cells, calculated at the time 'T-1', and the fourth voltage deviation variance ΔdV_"T", which is the deviation of the OCV of each of the plurality of target cells, calculated at the time 'T'.

In operation S205, the controller 220 may diagnose at least one target battery cell based on at least any one of the pattern of the variance of the deviation of the OCV of each of the plurality of target battery cells, and a sum and a magnitude of variances of deviations of the OCVs.

In operation S205, according to an embodiment, the controller 220 may diagnose at least one target battery cell by comparing the pattern of the variance of the deviation of the OCV of each of the plurality of target battery cells with a plurality of pre-stored diagnosis patterns. Herein, the plurality of pre-stored diagnosis patterns may include a pattern of diagnosing a state of a battery cell with respect to a sum of variances ΔdV of a deviation of an OCV of a target battery cell, a pattern of diagnosing the state of the battery cell with respect to a magnitude of each variance of the deviation of the OCV of the target battery cell, a pattern of diagnosing the state of the battery cell with respect to a maximum magnitude or a minimum magnitude of the variance ΔdV of the deviation of the OCV of the target battery cell, and a pattern of diagnosing the state of the battery cell with respect to an increase or decrease trend of the variance ΔdV of the deviation of the OCV of the target battery cell.

In operation S205, when a pattern of a variance of a deviation of an OCV of at least one target battery cell among the plurality of target battery cells corresponds to any one of a plurality of diagnosis patterns, the controller 220 may diagnose that an inner short-circuit occurs in the corresponding target battery cell.

In operation S205, when the controller 220 determines that the inner short-circuit occurs in a battery cell, as a result of diagnosis, the controller 220 may provide information about the battery cell to a user. In operation S205, for example, the controller 220 may provide information about the battery cell having internal short-circuit occurring to a user terminal through a communication unit (not shown) and provide the information about the battery cell through a display provided in a vehicle, a charger, etc.

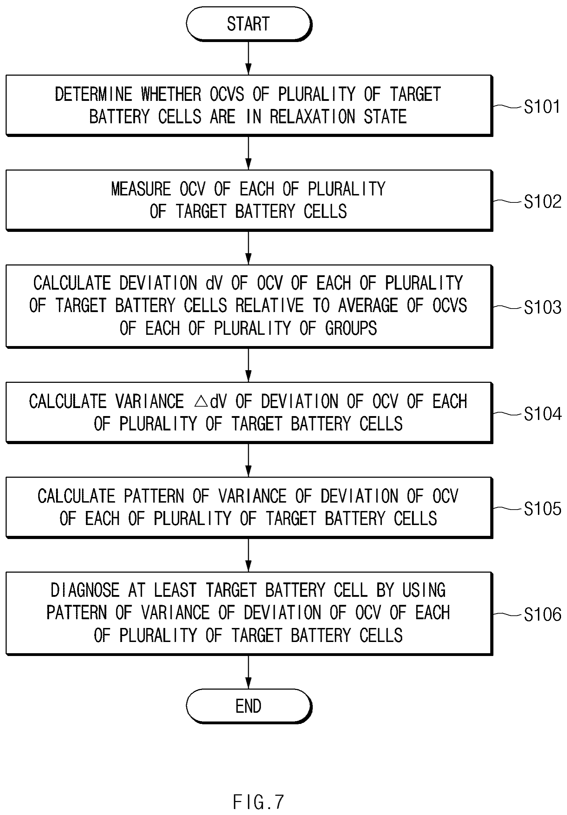

FIG. 7 is a block diagram showing a hardware configuration of a computing system for performing an operating method of a battery management apparatus, according to an embodiment disclosed herein.

Referring to FIG. 7, a computing system 2000 according to an embodiment disclosed herein may include an MCU 2100, a memory 2200, an input/output I/F 2300, and a communication I/F 2400.

The MCU 2100 may be a processor that executes various programs (e.g., a battery voltage change amount analysis program, etc.) stored in the memory 2200, processes various data through these programs, and perform the above-described functions of the battery management apparatus 200 shown in FIG. 1.

The memory 2200 may store various programs regarding operations of the battery management apparatus 200.

Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

[Description of Symbols]

1000: Battery Pack
100: Battery Module
110: First Battery Cell
120: Second Battery Cell
130: Third Battery Cell
140: Fourth Battery Cell
200: Battery Management Apparatus
210: Data Management Unit
220: Controller
300: Relay
2000: Computing System
2100: MCU
2200: Memory
2300: Input/Output I/F
2400: Communication I/F

**Claims**

1. A battery management apparatus comprising:

   a data management unit configured to calculate a degradation degree (a state of health (SOH)) of each of a plurality of batteries; and
   a controller configured to:

   identify a plurality of target batteries based on a first value that is a deviation of the SOH of each of the plurality of batteries relative to an average of the SOHs of the plurality of batteries;
   divide the plurality of target batteries into a plurality of groups based on SOHs thereof; and
   diagnose at least one target battery based on deviations of open circuit voltages (OCVs) between a plurality of target batteries included in each of the plurality of groups.

2. The battery management apparatus of claim 1, wherein the controller is further configured to identify, as the plurality of target batteries, batteries having the first value being less than a threshold among the plurality of batteries.

3. The battery management apparatus of claim 2, wherein the controller is further configured to divide the plurality of target batteries into a plurality of groups in an order in which the plurality of target batteries are listed in a descending order of the SOHs thereof.

4. The battery management apparatus of claim 3, wherein the controller is further configured to calculate a deviation of an OCV of each of a plurality of target batteries included in each of the plurality of groups relative to an average of OCVs of the plurality of target batteries and calculate a variance of the deviation of the OCV of each of the plurality of target batteries included in each of the plurality of groups.

5. The battery management apparatus of claim 4, wherein the controller is further configured to calculate a pattern of the variance of the deviation of the OCV of each of the plurality of target batteries by calculating the variance of the deviation of the OCV of each of the plurality of target batteries every specific periods, and diagnose at least one target battery by comparing the pattern of the variance of the deviation of the OCV of each of the plurality of target batteries with a plurality of diagnosis patterns.

6. The battery management apparatus of claim 5, wherein the controller is further configured to diagnose at least one target battery among the plurality of target batteries when a pattern of a variance of a deviation of an OCV of the at least one target battery corresponds to any one of the plurality of diagnosis patterns.

7. An operating method of a battery management apparatus, the operating method comprising:

calculating a degradation degree (a state of health (SOH)) of each of a plurality of batteries;
calculating a first value that is a deviation of the SOH of each of the plurality of batteries relative to an average of the SOHs of the plurality of batteries;
identifying a plurality of target batteries based on the first value of each of the plurality of batteries;
dividing the plurality of target batteries into a plurality of groups based on SOHs thereof; and
diagnosing at least one target battery based on deviations of open circuit voltages (OCVs) between a plurality of target batteries included in each of the plurality of groups.

8. The operating method of claim 7, wherein the identifying of the plurality of target batteries based on the first value of each of the plurality of batteries comprises identifying, as the plurality of target batteries, batteries having the first value being less than a threshold among the plurality of batteries.

9. The operating method of claim 8, wherein the dividing of the plurality of target batteries into the plurality of groups based on the SOHs thereof comprises dividing the plurality of target batteries into a plurality of groups in an order in which the plurality of target batteries are listed in a descending order of the SOHs thereof.

10. The operating method of claim 9, wherein the diagnosing of the at least one target battery based on the deviations of the OCVs between the plurality of target batteries included in each of the plurality of groups comprises calculating a deviation of an OCV of each of a plurality of target batteries included in each of the plurality of groups relative to an average of OCVs of the plurality of target batteries and calculating a variance of the deviation of the OCV of each of the plurality of target batteries included in each of the plurality of groups.

11. The operating method of claim 10, wherein the diagnosing of the at least one target battery based on the deviations of the OCVs between the plurality of target batteries included in each of the plurality of groups comprises calculating a pattern of the variance of the deviation of the OCV of each of the plurality of target batteries by calculating the variance of the deviation of the OCV of each of the plurality of target batteries every specific periods, and diagnosing at least one target battery by comparing the pattern of the variance of the deviation of the OCV of each of the plurality of target batteries with a plurality of diagnosis patterns.

12. The operating method of claim 11, wherein the diagnosing of the at least one target battery based on the deviations of the OCVs between the plurality of target batteries included in each of the plurality of groups comprises diagnosing at least one target battery among the plurality of target batteries when a pattern of a variance of a deviation of an OCV of the at least one target battery corresponds to any one of the plurality of diagnosis patterns.

1000

300

110

111

112

113

⋮

114

BATTERY MANAGEMENT
APPARATUS
200

FIG.1

200

```
┌──────────────────────┐          ┌──────────────────────┐
│  DATA  MANAGEMENT    │          │                      │
│       UNIT           │──────────│    CONTROLLER        │
│       210            │          │        220           │
└──────────────────────┘          └──────────────────────┘
```

FIG.2

| BATTERY CELL NUMBER | DEGRADATION DEGREE(SOH)[%] | BATTERY MODULE |
|---|---|---|
| 1 | 98.83 | 1 |
| 2 | 98.03 | 1 |
| 3 | 98.99 | 1 |
| 4 | 98.41 | 1 |
| 5 | 98.38 | 1 |
| 6 | 98.48 | 1 |
| 7 | 98.83 | 1 |
| 8 | 98.09 | 1 |
| 9 | 98.67 | 1 |
| 10 | 98.69 | 1 |
| 11 | 95.24 | 2 |
| 12 | 98.01 | 2 |
| 13 | 98.65 | 2 |
| 14 | 98.15 | 2 |
| 15 | 98.86 | 2 |
| 16 | 98.26 | 2 |
| 17 | 98.37 | 2 |
| 18 | 98.75 | 2 |
| 19 | 98.83 | 2 |
| 20 | 98.31 | 2 |
| 21 | 98.92 | 3 |
| 22 | 98.86 | 3 |
| 23 | 95.55 | 3 |
| 24 | 98.61 | 3 |
| 25 | 98.26 | 3 |
| 26 | 98.04 | 3 |
| 27 | 98.12 | 3 |
| 28 | 98.35 | 3 |
| 29 | 98.34 | 3 |
| 30 | 98.72 | 3 |
| 31 | 98.64 | 4 |
| 32 | 98.45 | 4 |
| 33 | 98.39 | 4 |
| 34 | 98.13 | 4 |
| 35 | 98.14 | 4 |
| 36 | 98.29 | 4 |
| 37 | 98.17 | 4 |
| 38 | 98.29 | 4 |
| 39 | 98.61 | 4 |
| 40 | 98.90 | 4 |

FIG.3

| BATTERY CELL NUMBER | DEGRADATION DEGREE(SOH)[%] | BATTERY MODULE | FIRST VALUE [%] |
|---|---|---|---|
| 1 | 98.83 | 1 | -0.44 |
| 2 | 98.03 | 1 | 0.35 |
| 3 | 98.99 | 1 | -0.60 |
| 4 | 98.41 | 1 | -0.03 |
| 5 | 98.38 | 1 | 0.01 |
| 6 | 98.48 | 1 | -0.01 |
| 7 | 98.83 | 1 | -0.45 |
| 8 | 98.09 | 1 | 0.29 |
| 9 | 98.67 | 1 | -0.28 |
| 10 | 98.69 | 1 | -0.31 |
| 11 | 95.24 | 2 | 3.14 |
| 12 | 98.01 | 2 | 0.37 |
| 13 | 98.65 | 2 | -0.26 |
| 14 | 98.15 | 2 | 0.23 |
| 15 | 98.86 | 2 | -0.48 |
| 16 | 98.26 | 2 | 0.12 |
| 17 | 98.37 | 2 | 0.01 |
| 18 | 98.75 | 2 | -0.36 |
| 19 | 98.83 | 2 | -0.45 |
| 20 | 98.31 | 2 | 0.08 |
| 21 | 98.92 | 3 | -0.54 |
| 22 | 98.86 | 3 | -0.48 |
| 23 | 95.55 | 3 | 2.83 |
| 24 | 98.61 | 3 | -0.23 |
| 25 | 98.26 | 3 | 0.12 |
| 26 | 98.04 | 3 | 0.34 |
| 27 | 98.12 | 3 | 0.26 |
| 28 | 98.35 | 3 | 0.03 |
| 29 | 98.34 | 3 | 0.04 |
| 30 | 98.72 | 3 | -0.33 |
| 31 | 98.64 | 4 | -0.26 |
| 32 | 98.45 | 4 | -0.07 |
| 33 | 98.39 | 4 | -0.01 |
| 34 | 98.13 | 4 | 0.25 |
| 35 | 98.14 | 4 | 0.24 |
| 36 | 98.29 | 4 | 0.09 |
| 37 | 98.17 | 4 | 0.22 |
| 38 | 98.29 | 4 | 0.10 |
| 39 | 98.61 | 4 | -0.23 |
| 40 | 98.90 | 4 | -0.52 |

FIG.4

| BATTERY CELL NUMBER | DEGRADATION DEGREE(SOH)[%] | GROUP NUMBER |
|---|---|---|
| 1 | 98.83 | 1 |
| 3 | 98.99 | 1 |
| 7 | 98.83 | 1 |
| 15 | 98.86 | 1 |
| 18 | 98.75 | 1 |
| 19 | 98.83 | 1 |
| 21 | 98.92 | 1 |
| 22 | 98.86 | 1 |
| 30 | 98.72 | 1 |
| 40 | 98.90 | 1 |
| 4 | 98.41 | 2 |
| 6 | 98.48 | 2 |
| 9 | 98.67 | 2 |
| 10 | 98.69 | 2 |
| 13 | 98.65 | 2 |
| 24 | 98.61 | 2 |
| 31 | 98.64 | 2 |
| 32 | 98.45 | 2 |
| 39 | 98.61 | 2 |
| 5 | 98.38 | 2 |
| 16 | 98.26 | 3 |
| 17 | 98.37 | 3 |
| 20 | 95.31 | 3 |
| 25 | 98.26 | 3 |
| 28 | 98.35 | 3 |
| 29 | 98.34 | 3 |
| 33 | 98.39 | 3 |
| 36 | 98.29 | 3 |
| 38 | 98.29 | 3 |
| 2 | 98.03 | 3 |
| 8 | 98.09 | 4 |
| 12 | 98.01 | 4 |
| 14 | 98.15 | 4 |
| 26 | 98.04 | 4 |
| 27 | 98.12 | 4 |
| 34 | 98.13 | 4 |
| 35 | 98.14 | 4 |
| 37 | 98.17 | 4 |

FIG.5

```
                        ┌──────────────┐
                        │    START     │
                        └──────────────┘
                               │
                               ▼
     ┌─────────────────────────────────────────────────────┐
     │  CALCULATE SOH OF EACH OF PLURALITY OF BATTERIES     │───S201
     └─────────────────────────────────────────────────────┘
                               │
                               ▼
     ┌─────────────────────────────────────────────────────┐
     │   CALCULATE FIRST VALUE THAT IS DEVIATION OF SOH     │
     │    OF EACH OF PLURALITY OF BATTERIES RELATIVE        │───S202
     │   TO AVERAGE OF SOHS OF PLURALITY OF BATTERIES       │
     └─────────────────────────────────────────────────────┘
                               │
                               ▼
     ┌─────────────────────────────────────────────────────┐
     │   IDENTIFY PLURALITY OF TARGET BATTERIES BASED ON    │
     │    FIRST VALUE OF EACH OF PLURALTIY OF BATTERIES     │───S203
     └─────────────────────────────────────────────────────┘
                               │
                               ▼
     ┌─────────────────────────────────────────────────────┐
     │     DIVIDE PLURALITY OF TARGET BATTERIES INTO        │
     │        PLURALITY OF GROUPS BASED ON SOHS             │───S204
     └─────────────────────────────────────────────────────┘
                               │
                               ▼
     ┌─────────────────────────────────────────────────────┐
     │   DIAGNOSE AT LEAST ONE TARGET BATTERY BASED ON      │
     │  DEVIATIONS OF OCVS BETWEEN PLURALITY OF TARGET      │───S205
     │  BATTERIES INCLUDED IN EACH OF PLURALITY OF GROUPS   │
     └─────────────────────────────────────────────────────┘
                               │
                               ▼
                        ┌──────────────┐
                        │     END      │
                        └──────────────┘
```

FIG.6

```
                          ╭─────────────╮
                          │    START    │
                          ╰──────┬──────╯
                                 │
                                 ▼
        ┌──────────────────────────────────────────────────┐
        │ DETERMINE WHETHER OCVS OF PLURALITY OF TARGET      │─── S101
        │      BATTERY CELLS ARE IN RELAXATION STATE         │
        └───────────────────────┬──────────────────────────┘
                                 │
                                 ▼
        ┌──────────────────────────────────────────────────┐
        │        MEASURE OCV OF EACH OF PLURALITY           │─── S102
        │           OF TARGET BATTERY CELLS                 │
        └───────────────────────┬──────────────────────────┘
                                 │
                                 ▼
        ┌──────────────────────────────────────────────────┐
        │ CALCULATE DEVIATION dV OF OCV OF EACH OF PLURALITY │
        │ OF TARGET BATTERY CELLS RELATIVE TO AVERAGE OF OCVS│─── S103
        │        OF EACH OF PLURALITY OF GROUPS             │
        └───────────────────────┬──────────────────────────┘
                                 │
                                 ▼
        ┌──────────────────────────────────────────────────┐
        │ CALCULATE VARIANCE △dV OF DEVIATION OF OCV OF EACH │─── S104
        │        OF PLURALITY OF TARGET BATTERY CELLS        │
        └───────────────────────┬──────────────────────────┘
                                 │
                                 ▼
        ┌──────────────────────────────────────────────────┐
        │ CALCULATE PATTERN OF VARIANCE OF DEVIATION OF OCV  │─── S105
        │      OF EACH OF PLURALITY OF TARGET BATTERY CELLS  │
        └───────────────────────┬──────────────────────────┘
                                 │
                                 ▼
        ┌──────────────────────────────────────────────────┐
        │  DIAGNOSE AT LEAST TARGET BATTERY CELL BY USING    │
        │  PATTERN OF VARIANCE OF DEVIATION OF OCV OF EACH    │─── S106
        │      OF PLURALITY OF TARGET BATTERY CELLS          │
        └───────────────────────┬──────────────────────────┘
                                 │
                                 ▼
                          ╭─────────────╮
                          │     END     │
                          ╰─────────────╯
```

FIG.7

2000

2200                                    2400

| MEMORY |        | COMMUNICATION I/F |

| MCU |           | INPUT/OUTPUT I/F |

2100                                    2300

FIG.8

## INTERNATIONAL SEARCH REPORT

| | International application No. |
| --- | --- |
| | **PCT/KR2024/003171** |

### A. CLASSIFICATION OF SUBJECT MATTER

**G01R 31/392**(2019.01)i; **G01R 31/396**(2019.01)i; **G01R 31/385**(2019.01)i; **G01R 19/165**(2006.01)i; **B60L 58/16**(2019.01)i

According to International Patent Classification (IPC) or to both national classification and IPC

### B. FIELDS SEARCHED

Minimum documentation searched (classification system followed by classification symbols)

G01R 31/392(2019.01); B60L 58/16(2019.01); G01R 31/36(2006.01); G01R 31/367(2019.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 퇴화도(SOH, State Of Health), 편차(deviation), 그룹 (group), 개방 회로 전압(OCV, Open Circuit Voltage)

### C. DOCUMENTS CONSIDERED TO BE RELEVANT

| Category* | Citation of document, with indication, where appropriate, of the relevant passages | Relevant to claim No. |
| --- | --- | --- |
| A | US 2019-0170827 A1 (CADEX ELECTRONICS INC.) 06 June 2019 (2019-06-06)<br>See paragraph [0035]; claims 1-13; and figure 1. | 1-12 |
| A | KR 10-2021-0136496 A (HYUNDAI MOTOR COMPANY et al.) 17 November 2021 (2021-11-17)<br>See claims 1-2. | 1-12 |
| A | KR 10-2012-0076068 A (LG CHEM, LTD.) 09 July 2012 (2012-07-09)<br>See claim 1; and figure 5. | 1-12 |
| A | KR 10-2016-0004077 A (SAMSUNG ELECTRONICS CO., LTD.) 12 January 2016 (2016-01-12)<br>See paragraphs [0092]-[0094]; and figure 11. | 1-12 |
| A | KR 10-2424165 B1 (SK ON CO., LTD.) 25 July 2022 (2022-07-25)<br>See paragraphs [0033]-[0043]; and figure 3. | 1-12 |

| ☐ Further documents are listed in the continuation of Box C. | ☑ See patent family annex. |
| --- | --- |

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **17 June 2024** | **18 June 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/003171**

| Patent document cited in search report | | | Publication date (day/month/year) | Patent family member(s) | | | Publication date (day/month/year) |
|---|---|---|---|---|---|---|---|
| US | 2019-0170827 | A1 | 06 June 2019 | US | 11079437 | B2 | 03 August 2021 |
| | | | | US | 2019-0170826 | A1 | 06 June 2019 |
| KR | 10-2021-0136496 | A | 17 November 2021 | CN | 113625171 | A | 09 November 2021 |
| | | | | DE | 102020212732 | A1 | 11 November 2021 |
| | | | | US | 2021-0349156 | A1 | 11 November 2021 |
| KR | 10-2012-0076068 | A | 09 July 2012 | EP | 2660616 | A1 | 06 November 2013 |
| | | | | EP | 2660616 | A4 | 06 September 2017 |
| | | | | EP | 2660616 | B1 | 19 September 2018 |
| | | | | KR | 10-1293635 | B1 | 05 August 2013 |
| | | | | PL | 2660616 | T3 | 31 January 2019 |
| | | | | US | 2012-0274281 | A1 | 01 November 2012 |
| | | | | US | 9000732 | B2 | 07 April 2015 |
| | | | | WO | 2012-091287 | A1 | 05 July 2012 |
| KR | 10-2016-0004077 | A | 12 January 2016 | CN | 105277888 | A | 27 January 2016 |
| | | | | CN | 105277888 | B | 05 November 2019 |
| | | | | EP | 2963433 | A1 | 06 January 2016 |
| | | | | EP | 2963433 | B1 | 14 April 2021 |
| | | | | KR | 10-2225667 | B1 | 12 March 2021 |
| | | | | US | 10393819 | B2 | 27 August 2019 |
| | | | | US | 2016-0003917 | A1 | 07 January 2016 |
| KR | 10-2424165 | B1 | 25 July 2022 | CN | 116008841 | A | 25 April 2023 |
| | | | | DE | 102022127910 | A1 | 27 April 2023 |
| | | | | US | 2023-0132102 | A1 | 27 April 2023 |

Form PCT/ISA/210 (patent family annex) (July 2022)

**EP 4 671 790 A1**

REFERENCES CITED IN THE DESCRIPTION

**Patent documents cited in the description**

- KR 1020230042995